# DEMANDE DE BREVET EUROPEEN

(11) **EP 2 911 488 A1**
(43) Date de publication de la demande: **26.08.2015**
(21) Numéro de dépôt: 15155338.5
(22) Date de dépôt: 17.02.2015
(51) Int. Cl.: H05K 7/20

(54) **Système de régulation thermique d'au moins un module électronique embarqué à bord d'un aéronef**

(30) Priorité: 21.02.2014 FR 1400460
(71) Demandeur: Thales, 92400 Courbevoie (FR)
(72) Inventeur: Sarno, Claude, 26800 ETOILE SUR RHONE (FR); Oconte, Philippe, 26250 LIVRON-SUR-DROME (FR); Hodot, Romain, 26000 VALENCE (FR)
(74) Mandataire: Brunelli, Gérald

(57) **Abrégé**

Système de régulation thermique (1) d'au moins un équipement (2) embarqué à bord d'un aéronef, comprenant un circuit de régulation thermique (5) connecté au(x) équipement(s) (2), ledit circuit de régulation thermique (5) comprenant un dispositif modulaire (6) de régulation thermique adapté pour recevoir un nombre modifiable de modules (8) de régulation thermique.

## Description

La présente invention porte sur un système de régulation thermique d'au moins un module électronique embarqué à bord d'un aéronef.

Les matériels électroniques dits "embarqués" sont amenés à fonctionner dans des conditions difficiles, notamment de vibrations, chocs, humidité, accélérations, et confinement (problèmes de chaleur et de surchauffe).

Ces conditions difficiles ont tendance à entrainer sur ces matériels électroniques des défauts de fonctionnement, malgré toutes les précautions prises lors de leur conception et de leur fabrication. Ceci conduit à concevoir ces matériels électroniques en vue de favoriser leur dépannage et leur maintenance, et à cet effet, ces matériels électroniques doivent répondre à de nouvelles normes.

Les matériels électroniques utilisés à bord d'aéronefs, en vue notamment de faciliter l'échange d'un matériel défectueux, l'une des nouvelles normes citées plus haut prévoit de réaliser ces matériels électroniques (souvent désignés par le terme "d'avionique modulaire") sous la forme de structures modulaires appelées LRM, acronyme de "Line Replaceable Module" en langue anglaise, pour Module Remplaçable en Ligne.

Ces structures modulaires appelées modules électroniques dans la suite de la description, sont formés selon des boîtiers, généralement installés dans des racks pouvant regrouper un nombre important de ces modules électroniques. Bien entendu, dans des aéronefs de plus petite taille, tels de petits avions ou des hélicoptères, les racks sont plus petits voire inexistants et les modules électroniques répartis à différents endroits de l'aéronef.

Cela, va bien dans le sens de faciliter la maintenance, la manutention et le dépannage rapide, mais tend a rendre plus difficile l'évacuation de la chaleur produite par les divers composants contenus dans les modules. En outre les composants électroniques utilisés sont de plus en plus sophistiqués et tendent à produire de plus en plus d'énergie thermique dont l'évacuation est difficile.

Il est connu des systèmes centralisés au niveau d'un aéronef qui distribue généralement de l'air, plus rarement du liquide, au niveau des équipements, pour réguler leur température. Un tel système est complexe notamment en ce qui concerne les tuyauteries de distribution qui sont volumineuses et de grande longueur entre la centrale de refroidissement ou ECS pour acronyme de "Environment Control System" en langue anglaise et les équipements. En outre, les équipements, notamment les modules électroniques, pour des puissances élevées ou des points chauds, sont bruyants du fait des vitesses d'air élevées dans les conduits.

Il est également connu des systèmes locaux à base de ventilateurs, généralement redondés, qui manquent de fiabilité et créent de forts risques de pollution du fait de la circulation de l'air directement sur les composants. En outre, l'air est relâché localement et peut surchauffer les zones concernées (auto échauffement). Ces systèmes peuvent aussi être bruyants en cas de forte puissance (bruit des ventilateurs et de l'air).

L'augmentation de puissance au niveau des composants à forte densité (processeurs multi-coeurs, fpga) crée des points chauds dont le refroidissement n'est plus compatible avec des systèmes de refroidissement standard à air, centralisés ou locaux. Une partie de la puissance doit être déportée pour être dissipée dans les zones distantes plus propices (taille, bruit, points froids naturels, ...)

Un but de l'invention est de pallier ces problèmes.

Un but de l'invention est de fournir un système de régulation thermique modulable, adaptable à tout type d'aéronefs, tel un avion de ligne, un avion de petite taille ou un hélicoptère.

Il est proposé, selon un aspect de l'invention, un système de régulation thermique d'au moins un équipement embarqué à bord d'un aéronef, comprenant :
un circuit de régulation thermique externe au(x)dit(s) équipement(s) et connecté au(x)dit(s) équipement(s), ledit circuit de régulation thermique comprenant un dispositif modulaire de régulation thermique adapté pour recevoir un nombre modifiable de modules de régulation thermique de nature différente, le dispositif modulaire de régulation thermique comprenant un châssis adapté pour recevoir un nombre modifiable de modules de régulation thermique;
ledit circuit de régulation thermique comprenant au moins un connecteur thermique connecté à un module électronique embarqué.

Un tel système permet, à coût réduit, de proposer un système de régulation thermique modulable en fonction de l'équipement de l'aéronef, et adaptable à la taille de l'aéronef. Par exemple il est autant adapté à un avion de grande taille, qu'à un avion de petite taille ou un hélicoptère.

Le dispositif modulaire de régulation thermique pouvant, par exemple comprendre une base ou rack ou châssis capable de recevoir un nombre modifiable de modules de régulation thermique enfichables et amovibles. Ainsi un fournisseur d'équipement électronique peut fournir simultanément sa fonction électronique et le module de régulation thermique associé, l'ensemble étant qualifié préalablement.

Ainsi la modularité est aisément réalisable.

On peut donc avantageusement refroidir les points chauds de modules électroniques comprenant généralement des cartes électroniques munies de puissants processeurs générant localement de très importants dégagements de chaleur. De tels connecteurs thermiques sont, par exemple décrits dans le document FR2920946.

Dans un mode de réalisation, le ou les équipement(s) comprennent au moins un module électronique.

Un système selon un aspect de l'invention est particulièrement bien adapté à la régulation thermique de modules électroniques pouvant dégager de fortes chaleurs, et même générer des points chauds.

Dans un mode de réalisation, le système comprend au moins un châssis adapté pour recevoir un nombre modifiable de modules électroniques embarqués.

Ainsi, le système est également bien adapté pour des aéronefs de taille importante, comprenant généralement un ou plusieurs châssis adaptés pour recevoir un nombre modifiable de modules électroniques embarqués. Un tel châssis est par exemple décrit dans le document FR2803166.

Selon un mode de réalisation, ledit circuit de régulation thermique comprend un fluide caloporteur diphasique.

L'utilisation d'un fluide caloporteur diphasique permet de ne pas avoir de moyens de mise en circulation du fluide caloporteur, car celui-ci circule par effet thermodynamique.

Dans un mode de réalisation, au moins un module de régulation thermique comprend au moins un condenseur.

Un tel mode de réalisation, permet de transporter de la chaleur sans forces extérieures, et donc avec une consommation d'énergie plus faible.

De plus, ces systèmes sont passifs et donc ont une plus grande fiabilité (pas d'éléments d'usure)

En variante, ledit circuit de régulation comprend un liquide caloporteur.

Par exemple, au moins un module de régulation thermique comprend au moins une pompe.

Un tel mode de réalisation, est plus facile à concevoir, et peut refroidir des modules de plus forte puissance, en augmentant le débit de la pompe (une redondance est préférable pour garantir une meilleure fiabilité).

Par exemple, au moins un module de régulation thermique comprend au moins un compresseur.

Un tel mode de réalisation, permet de créer du froid, contrairement aux systèmes précédents qui assurent un transport de chaleur, le système à compresseur peut par effet thermodynamique créer du froid avec un rendement intéressant.

Ces systèmes à compresseurs peuvent se combiner avec les systèmes précédemment décrits, diphasiques ou des systèmes à pompes pour le transport.

En variante, ledit circuit de régulation thermique comprend de l'air comme fluide caloporteur.

Par exemple, au moins un module de régulation thermique comprend au moins un ventilateur.

Un tel mode de réalisation permet d'utiliser l'air qui est l'élément le plus facilement disponible à bord des aéronefs, il peut donc être intéressant de créer des éléments modulaires distribuant de l'air destinée à refroidir le connecteur thermique

Selon un autre aspect de l'invention, il est également proposé un aéronef comprenant un système selon l'une des revendications précédentes.

L'invention sera mieux comprise à l'étude de quelques modes de réalisation décrits à titre d'exemples nullement limitatifs et illustrés par les dessins annexés sur lesquels :
- la figure 1 illustre schématiquement un système selon un aspect de l'invention ; et
- les figures 2 à 5 illustrent, des variantes de réalisation de l'invention.

Sur l'ensemble des figures, les éléments ayant des références identiques sont similaires.

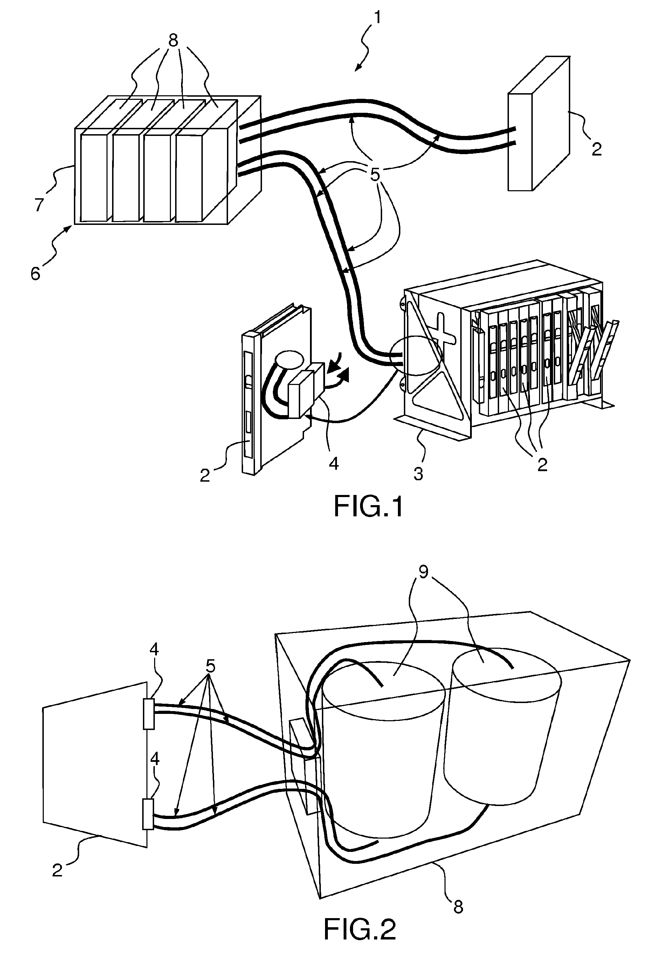

La figure 1 illustre schématiquement un système de régulation thermique selon un aspect de l'invention,

Un système de régulation thermique 1 d'au moins un module électronique 2 comprend, en l'espèce un module électronique seul 2, et un châssis ou rack 3 adapté pour recevoir un nombre modifiable de modules électroniques embarqués 2.

Un tel châssis est par exemple décrit dans la demande de brevet français FR2803166.

Bien entendu, l'invention s'applique à toute combinaison de plusieurs modules électroniques 2.

Comme représenté sur la figure 1, en bas à gauche, un module électronique 2 comprend un point chaud relié à un connecteur thermique 4, tel que décrit, par exemple, dans la demande de brevet français FR2929946.

Un tel connecteur thermique permet d'avoir lors d'un connexion/déconnexion, aucune perte de fluide caloporteur, car à l'interface prise mâle prise femelle du connecteur, n'a lieu aucun échange de fluide, car une boucle est présente d'un côté du connecteur et une autre boucle de l'autre.

Si le fluide caloporteur est diphasique, un connecteur thermique 4 peut comprendre un évaporateur.

Le système comprend également un circuit de régulation thermique 5 connecté au(x) module(s) électronique(s) 2, utilisant un fluide caloporteur pour réguler la température des modules électroniques 2, notamment les refroidir, car ceux-ci comportent généralement des cartes électroniques munies de processeurs puissants générant des points chauds dégageant une forte quantité de chaleur.

Sur l'exemple de la figure 1, les équipements représentés sont uniquement des modules électroniques indépendants, ou regroupés sur un châssis 3, mais bien entendu, le circuit de régulation thermique 5 peut également être connecté à tout autre équipement nécessitant une régulation thermique.

Le système de régulation thermique 1 comprend également un dispositif modulaire 6, pouvant par exemple comprendre une base ou rack 7 adaptés pour recevoir un nombre modulable modifiable de modules de régulation thermique 8.

Bien entendu tous les éléments de ce système sont commandés par une unité de commande électronique non représentée sur la figure, par retour d'informations en provenance d'un ensemble de capteurs, comme classiquement dans tout système de régulation thermique.

Le système de régulation thermique 1 comprend donc un dispositif modulaire 6 de régulation thermique pour lequel on peut adapter et/ou modifier le nombre de modules de régulation thermique qu'il reçoit en fonction du nombre d'équipements à réguler thermiquement.

Un tel système peut être relié aux connecteurs thermiques 4 par des tuyaux ou tubes de circulation du fluide caloporteur de faible section, ce qui est particulièrement intéressant lorsque les équipements à réguler thermiquement sont situés dans des zones présentant peu d'espace disponible ou lorsque les équipements à réguler thermiquement sont de petite taille. Il est alors possible d'envisager d'adapter les tuyaux ou tubes de circulation du fluide caloporteur à la manière des câbles électriques le long des cloisons ou autres ...

Un tel système 1 permet de faciliter la maintenance, et peut être redondé pour améliorer la disponibilité et la fiabilité du système.

En cas de remplacement ou d'ajout de nouveaux équipements, notamment de modules électroniques de plus en plus puissants, dégageant donc de plus en plus d'énergie thermique le système permet de remplacer et/ou ajouter autant de modules de régulation thermique que nécessaire. Par exemple, en cas d'ajout de nouveaux équipements 2, ces derniers peuvent être reliés à de nouveaux modules de régulation thermique 8 du système de régulation thermique 1, sans intervention lourde sur le reste du système 1.

Plusieurs modes de réalisation sont envisageables, dépendant notamment du fluide caloporteur choisi, du mode de transport (actif ou passif), et du type de refroidissement (passif, échangeur ou compresseur). En d'autres termes, pour un même fluide caloporteur, les modules de régulation thermique 8 peuvent être de nature différente, aussi il est possible de combiner les modes de réalisation qui suivent.

Un premier mode de réalisation est illustré sur la figure 2, pour lequel le fluide caloporteur est un liquide mono phasique, tels de l'eau ou du glycol. Un élément 2 à réguler thermiquement est relié au circuit de régulation thermique 5 par l'intermédiaire du connecteur thermique 4, le circuit de régulation thermique 5 reliant l'élément 2 à un module de régulation thermique 8. Le fluide caloporteur étant liquide, le module de régulation thermique 8 peut comprendre au moins une pompe 9, en l'espèce deux pompes 9, comme illustré sur la figure 2.

Ce mode de réalisation présente l'avantage de permettre des dissipations d'énergie importantes avec une simplicité de réalisation, car il existe des pompes de tailles différentes en fonction des débits et des pertes de charges à respecter.

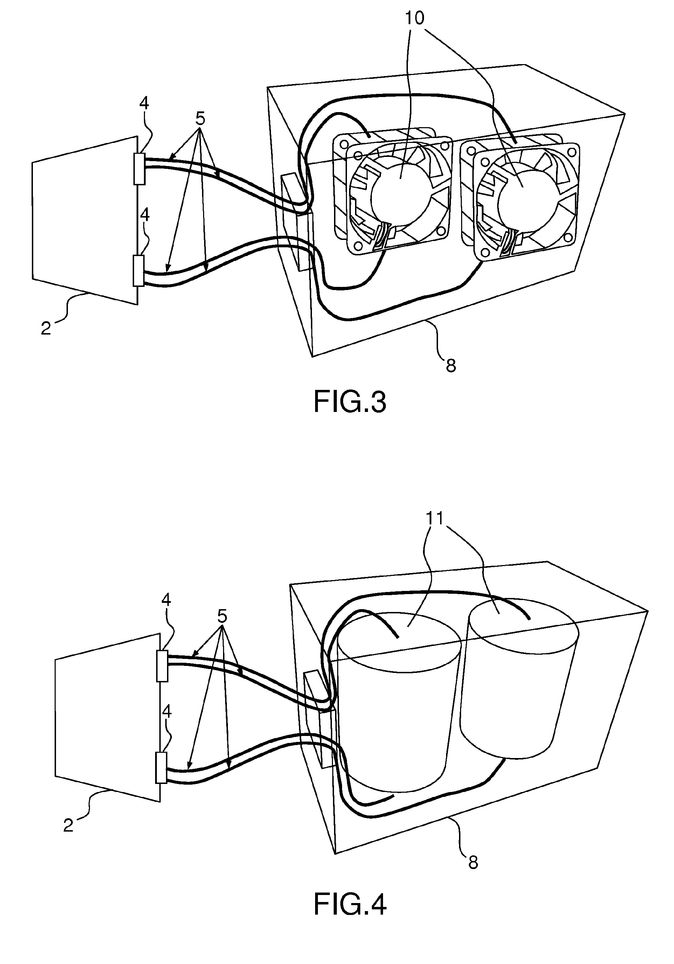

Un deuxième mode de réalisation est illustré sur la figure 3, pour lequel le fluide caloporteur est de l'air sous pression. Un élément 2 à réguler thermiquement est relié au circuit de régulation thermique 5 par l'intermédiaire de connecteur thermique 4, le circuit de régulation thermique 5 reliant l'élément 2 à un module de régulation thermique 8. Le fluide caloporteur étant de l'air sous pression, le module de régulation thermique 8 peut comprendre au moins un ventilateur 10, en l'espèce deux ventilateurs 10, comme illustré sur la figure 3.

Ce mode de réalisation présente l'avantage de ne pas nécessiter de circuit refroidisseur complémentaire, l'air pouvant être prélevé localement, et étant disponible sur tous les porteurs.

Un troisième mode de réalisation est illustré sur la figure 4, pour lequel le fluide caloporteur peut être un liquide monophasique ou de l'air

L'intérêt d'utiliser un compresseur est de permettre un refroidissement actif au dessous de la température ambiante, le transport de la chaleur peut s'effectuer par un système liquide monophasique ou par de l'air, les précédents modes de réalisation nécessitant un mécanisme de mise en mouvement actif (pompe ou ventilateurs). Un élément 2 à réguler thermiquement est relié au circuit de régulation thermique 5 par l'intermédiaire de connecteur thermique 4, le circuit de régulation thermique 5 reliant l'élément 2 à un module de régulation thermique 8. Le fluide caloporteur étant liquide, le module de régulation thermique 8 peut comprendre au moins un compresseur 11, en l'espèce deux compresseurs 11, comme illustré sur la figure 4.

Ce mode de réalisation présente l'avantage de pouvoir faire descendre le point froid en dessous de la température ambiante.

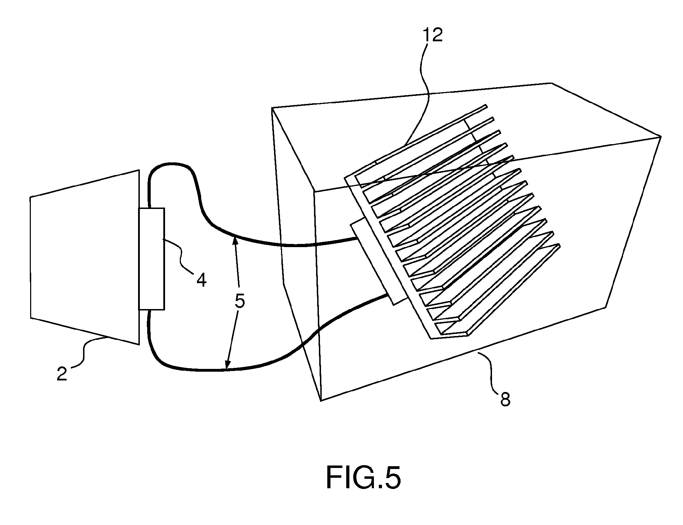

Un quatrième mode de réalisation est illustré sur la figure 5, pour lequel le fluide caloporteur est un système diphasique, par exemple , ce système permet de transporter la chaleur des éléments dissipatifs vers le refroidisseur sans nécessiter de force extérieure pour la mise en mouvement du fluide. Un élément 2 à réguler thermiquement est relié au circuit de régulation thermique 5 par l'intermédiaire du connecteur thermique 4, en l'espèce un évaporateur, le circuit de régulation thermique 5 reliant l'élément 2 à un module de régulation thermique 8. Le fluide caloporteur étant diphasique (liquide et gaz), le module de régulation thermique 8 peut comprendre au moins un condenseur 12, comme illustré sur la figure 5.

Ce mode de réalisation, employant un circuit de régulation thermique 5 diphasique passif à haute conductivité de type caloduc ou boucle diphasique présente l'avantage d'être totalement passif, i.e. de ne pas nécessiter de moyens de mise en circulation du fluide caloporteur, cette circulation étant liée à la thermodynamique.

Un système de régulation thermique selon un aspect de l'invention est facilement installable et maintenable.

Un tel système permet également de pendre en compte des densités de puissance élevées dans un encombrement réduit.

Un tel système permet, en outre, en cas de refroidissement d'un équipement, de séparer la zone dans laquelle on dissipe la chaleur de la zone dans laquelle s'effectue le refroidissement, ce qui permet d'avoir, à proximité des équipements, des conditions environnementales meilleures pour les équipements. Par exemple si on prend le cas d'une machine contenant des équipements embarqués et exposée au soleil, l'air ambiant ainsi que la structure sont à des températures très élevées, par conséquent il peut être plus avantageux d'isoler la zone des équipements et de les refroidir avec des compresseur pouvant être situés à une certaine distance des sources chaudes via les connecteurs thermiques.

En outre, en cas de forte humidité ou de brouillard salin, il est intéressant de ne pas souffler cet air directement sur les composants, ce qui diminuerait leur fiabilité, tandis que le système de refroidissement distant peut se trouver dans une zone protégée et connectée par des tubes à l'élément dissipatif

De tels modules de régulation thermique peuvent être utilisés dans des racks ou de manière isolés, aussi ils peuvent être fabriqués en série, ce qui limite le coût de fabrication unitaire.

## Revendications

1. Système de régulation thermique (1) d'au moins un équipement (2) embarqué à bord d'un aéronef, comprenant :
un circuit de régulation thermique (5) externe au(x)dit(s) équipement(s) et connecté au(x)dit(s) équipement(s) (2), ledit circuit de régulation thermique (5) comprenant un dispositif modulaire (6) de régulation thermique adapté pour recevoir un nombre modifiable de modules (8) de régulation thermique de nature différente, le dispositif modulaire (6) de régulation thermique comprenant un châssis (7) adapté pour recevoir un nombre modifiable de modules (8) de régulation thermique;
ledit circuit de régulation thermique (5) comprenant au moins un connecteur thermique (4) connecté à un module électronique embarqué.

2. Système selon la revendication 1, dans lequel le ou les équipement(s) (2) comprennent au moins un module électronique.

3. Système selon la revendication 2, comprenant au moins un châssis (3) adapté pour recevoir un nombre modifiable de modules électroniques embarqués.

4. Système selon l'une des revendications 1 à 3, dans lequel ledit circuit de régulation thermique (5) comprend un fluide caloporteur diphasique.

5. Système selon la revendication 4, dans lequel au moins un module de régulation thermique (8) comprend au moins un condenseur (12).

6. Système selon l'une des revendications 1 à 3, dans lequel ledit circuit de régulation thermique (5) comprend un liquide caloporteur.

7. Système selon la revendication 6, dans lequel au moins un module de régulation thermique (8) comprend au moins une pompe (9).

8. Système selon la revendication 6, dans lequel au moins un module de régulation thermique (8) comprend au moins un compresseur (11).

9. Système selon l'une des revendications 1 à 3, dans lequel ledit circuit de régulation thermique (5) comprend de l'air comme fluide caloporteur.

10. Système selon la revendication 9, dans lequel au moins un module de régulation thermique (8) comprend au moins un ventilateur (10).

11. Aéronef comprenant un système selon l'une des revendications précédentes.
